# EUROPÄISCHE PATENTSCHRIFT

(11) **EP 0 380 799 B1**
(45) Veröffentlichungstag und Bekanntmachung des Hinweises auf die Patenterteilung: **06.10.1993**
(21) Anmeldenummer: 89123290.2
(22) Anmeldetag: 15.12.1989
(51) Int. Cl.: H01L 23/482

(54) **Druckkontaktiertes Halbleiterbauelement**
Pressure contact semiconductor component
Composant semi-conducteur à contact de pression

(30) Priorität: 02.02.1989 CH 358/89
(43) Veröffentlichungstag der Anmeldung: 08.08.1990
(73) Patentinhaber: ASEA BROWN BOVERI AG, 5400 Baden (CH)
(72) Erfinder: Grüning, Horst, Dr., CH-5404 Baden (CH); Keser, Helmut, CH-5242 Birr (CH)

(56) Entgegenhaltungen:
- EP-A- 0 014 761
- EP-A- 0 080 953
- EP-A- 0 098 175
- EP-A- 0 285 074
- CH-A- 582 425
- DE-A- 3 346 833

## Beschreibung

### TECHNISCHES GEBIET

Die vorliegende Erfindung bezieht sich auf das Gebiet der Leistungselektronik. Sie betrifft insbesondere ein druckkontaktiertes Leistungshalbleiter-Bauelement nach dem Oberbegriff des ersten Anspruchs.

### STAND DER TECHNIK

Ein solches Bauelement ist z.B. aus der CH-A-582 425 bekannt.

Aufgrund der unterschiedlichen Ausdehnung von Si und dem Metall eines entsprechenden Kontaktes kann ein grossflächiges Leistungshalbleiter-Bauelement (Durchmesser >20 mm) nicht mehr direkt mit diesem Kontakt verlötet werden.

Zur Kontaktierung solcher Bauelemente sind aus diesem Grunde bisher zwei andere Wege beschritten worden:
-- der Legierkontakt; und
-- der direkte Druckkontakt (floating silicon).

Beim Legierkontakt (siehe dazu z.B.: EP-A2-0 146 928) wird das Bauelement einseitig, vorzugsweise mit der unstrukturierten Anode, auf eine Mo-Scheibe legiert, so dass ein guter thermischer und elektrischer Uebergang entsteht.

Die Verbindung muss aufgrund der hohen Prozesstemperatur (>600°C) aber vor der Fertigstellung des Bauelements erfolgen. Da zudem durch inhärente mechanische Spannungen in der Regel eine erhebliche Verwölbung des Si-Mo-Systems entsteht, stösst die Fertigung besonders der feinstrukturierten Bauelemente (GTO-Thyristor und FCTh) mit Legierkontakt auf erhebliche Schwierigkeiten.

Diese Schwierigkeiten werden beim direkten Druckkontakt (siehe die eingangs genannte Druckschrift) dadurch vermieden, dass das Bauelement zuerst fertiggestellt und dann zwischen zwei Anpressscheiben (üblicherweise Mo-Scheiben) gepresst wird. Hohe Anforderungen an die Planität, die Oberflächenqualität der Mo-Scheiben und die Einspannung sind dabei zu erfüllen. So können trotz aller Vorkehrungen speziell unter Dauerbeanspruchung (Wechsellast) und bei erneutem Einspannen des Bauelements Kontaktprobleme entstehen, die möglicherweise zur Zerstörung des Bauelements führen.

Aus den Europäischen Offenlegungsschriften EP-A-0 285 074 und EP-A-0 080 953 ist bekannt, dass zur Homogenisierung der Druckverteilung in druckkontaktierten Leistungshalbleiter-Bauelementen und damit zur Verbesserung der Zuverlässigkeit bei Lastwechselbeanspruchungen vorteilhafterweise Metallfolien zwischen den Anoden- bzw. Kathodenkontakten und den Anpresscheiben eingefügt werden.

In der Schweizerischen Patentschrift CH-A-582 425 wird nun beispielsweise vorgeschlagen, zwischen einer der Anpresscheiben und dem zugehörigen Kontakt ein Formteil anzuordnen. Diese Formteil weist eine geringe Dicke auf und ist in einer Ausführungsform mit dem Kontakt verlötet.

### DARSTELLUNG DER ERFINDUNG

Der Erfindung liegt daher die Aufgabe zugrunde, ein druckkontaktiertes Leistungshalbleiter-Bauelement zu schaffen, das sich durch eine verbesserte Zuverlässigkeit, insbesondere bei Wechselbeanspruchung, und durch eine Verringerung von thermischen Spannungen zwischen dem Substrat und der Folie auszeichnet.

Die Aufgabe wird bei einem Bauelement der eingangs genannten Art durch die Gesamtheit der Merkmale des unabhängigen Anspruchs 1 gelöst.

Der Kern der Erfindung besteht darin, durch eine dünne, aufgelötete Metallfolie zwischen wenigstens einer der Anpressscheiben und dem Substrat die Druckverteilung zu homogenisieren und gleichzeitig den thermischen und elektrischen Kontakt zu verbessern. Die Metallfolie ist dabei als feines Sieb ausgebildet und weist eine Vielzahl von flächig verteilten Sieblöchern auf.

Durch die Siebstruktur der Metallfolie werden Lunker bei der Lötung vermieden und thermische Spannungen zwischen dem Substrat und der Folie verringert.

Ein weiteres Ausführungsbeispiel zeichnet sich dadurch aus, dass
(a) die Metallfolie im Wesentlichen aus einem Metall der Reihe Cu und Mo besteht; und
(b) die Dicke der Metallfolie wenige 1/10 mm beträgt.

Die aufgelötete Metallfolie bringt besondere Vorteile bei Bauelementen mit stark strukturierter Kathodenseite (Kathodenfingern), nämlich bei einem GTO-Thyristor oder bei einem Feldgesteuerten Thyristor (FCTh).

Weitere Ausführungsbeispiele ergeben sich aus den Unteransprüchen.

### KURZE BESCHREIBUNG DER ZEICHNUNG

Nachfolgend soll die Erfindung anhand von Ausführungsbeispielen im Zusammenhang mit der Zeichnung näher erläutert werden. Es zeigen
- Fig.1: in perspektivischer Teilansicht den Aufbau eines FCTh nach dem Stand der Technik;
- Fig.2: eine bevorzugte laterale Struktur für einen aus mehreren Teilthyristoren gemäss Fig.1 zusammengesetzten Leistungs-FCTh;
- Fig.3: eine für die Kathoden-Kontaktierung des FCTh nach Fig.2 verwendete Metallfolie gemäss einem bevorzugten Ausführungsbeispiel der Erfindung;
- Fig.4: im Ausschnitt die Siebstruktur einer Metallfolie gemäss Fig.3; und
- Fig.5: im Schnitt die fertige druckkontaktierte Anordnung mit einem Bauelement gemäss Fig.2 und einer kathodenseitigen Metallfolie gemäss Fig.3.

### WEGE ZUR AUSFÜHRUNG DER ERFINDUNG

Nachfolgend wird ohne Beschränkung der Allgemeinheit das erfindungsgemässe Druckkontakt-System am Beispiel eines grossflächigen Leistungs-FCTh erläutert. Es versteht sich von selbst, dass die Erfindung auch bei anderen grossflächigen Halbleiterbauelementen, beispielsweise GTOs oder auch herkömmlichen Thyristoren, Transistoren oder Dioden Verwendung finden kann.

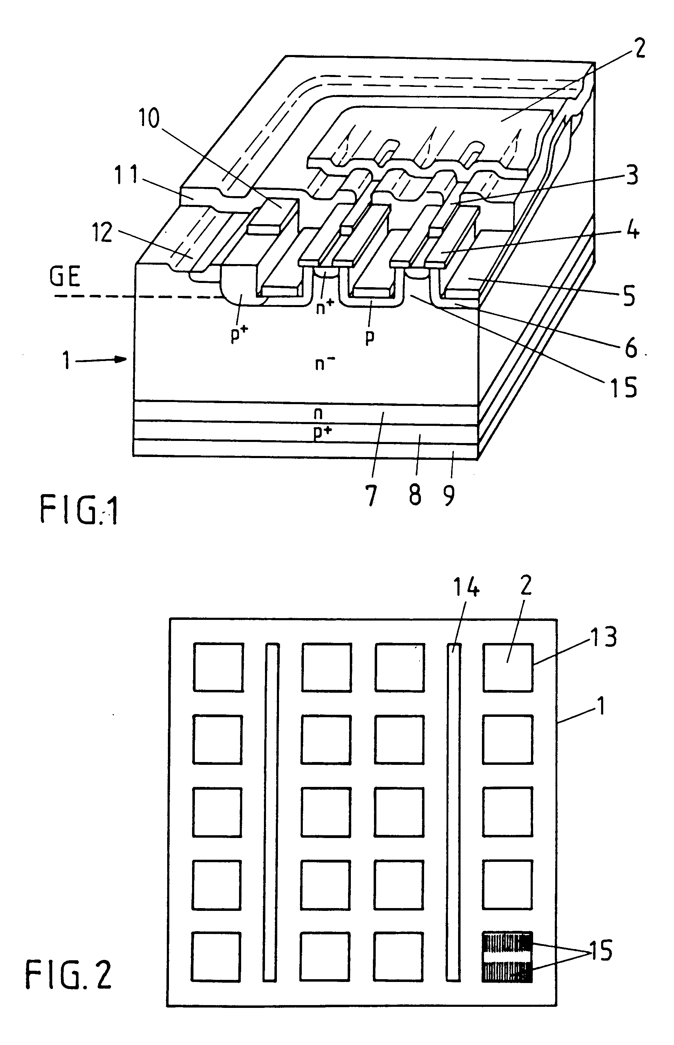

In Fig.1 ist in perspektivischer Teilansicht der Aufbau eines FCTh dargestellt, wie er aus dem Stand der Technik bekannt ist.

Ein solcher FCTh umfasst ein Substrat 1 aus schwach n-dotiertem Si, welches auf der (unteren) Anodenseite eine p⁺-dotierte Anodenschicht 8 enthält, die mit einem metallischen Anodenkontakt 9 kontaktiert ist. Zusätzlich kann oberhalb der Anodenschicht 8 noch eine n-dotierte Bufferschicht 7 vorgesehen sein.

Auf der (oberen) Kathodenseite des Substrats 1 ist eine Vielzahl von länglichen Kathodenfingern 15 vorgesehen, die aus einer tieferliegenden Gateebene GE herausragen. Innerhalb der Kathodenfinger 15 bildet das n⁻-dotierte Substratmaterial zusammen mit den angrenzenden, p-dotierten Gatebereichen 6 jeweils einen feldeffektgesteuerten Langkanal, dessen Funktionsweise aus der Literatur hinlänglich bekannt ist und daher hier nicht näher erläutert werden soll.

Die Kathodenfinger 15 sind über eine Kathodenmetallisierung 3 mit einem Kathodenkontakt 2 verbunden. Die Gatebereiche 6 stehen über eine in der Gateebene GE liegende Gatemetallisierung 5 in Verbindung mit einem Gatekontakt 10.

Kathodenkontakt 2 und Gatekontakt 10 sowie Gatemetallisierung 5 sind durch eine Passivierungsschicht 11 voneinander elektrisch getrennt. Zur Erhöhung der Spannungsfestigkeit ist am Rande des Bauelements ein Randabschluss 12 in Form eines Grabens vorgesehen.

Ein FCTh-Element, wie es in Fig.1 dargestellt ist, kann z.B. zwei parallele Reihen von je 50 Kathodenfingern umfassen und bildet dann einen Teilthyristor relativ kleiner Leistung.

Wird nun eine Vielzahl von solchen Teilthyristoren auf einem Substrat grösserer Fläche nebeneinander in Parallelschaltung integriert, erhält man einen grossflächigen FCTh hoher Leistung.

Die laterale Struktur eines derartigen FCTh, der zur Erläuterung der Erfindung herangezogen werden soll, ist in Fig.2 wiedergegeben. Das Substrat 1 enthält bei diesem Beispiel auf einer Fläche von 23 x 23 mm² in vier Reihen zu je fünf Einzelelementen insgesamt 20 Teilthyristoren 13, die ihrerseits jeweils 2 x 50 Kathodenfinger 15 umfassen und eine Kantenlänge von etwa 3 mm aufweisen.

Jeder Teilthyristor 13 hat einen inneren Aufbau gemäss Fig.1 und ist mit einem eigenen Kathodenkontakt 2 versehen. Zwischen zwei Reihen von Teilthyristoren 13 sind längliche Gatekontakte 14 angeordnet, die mit den Gatemetallisierungen der angrenzenden Teilthyristoren in Verbindung stehen.

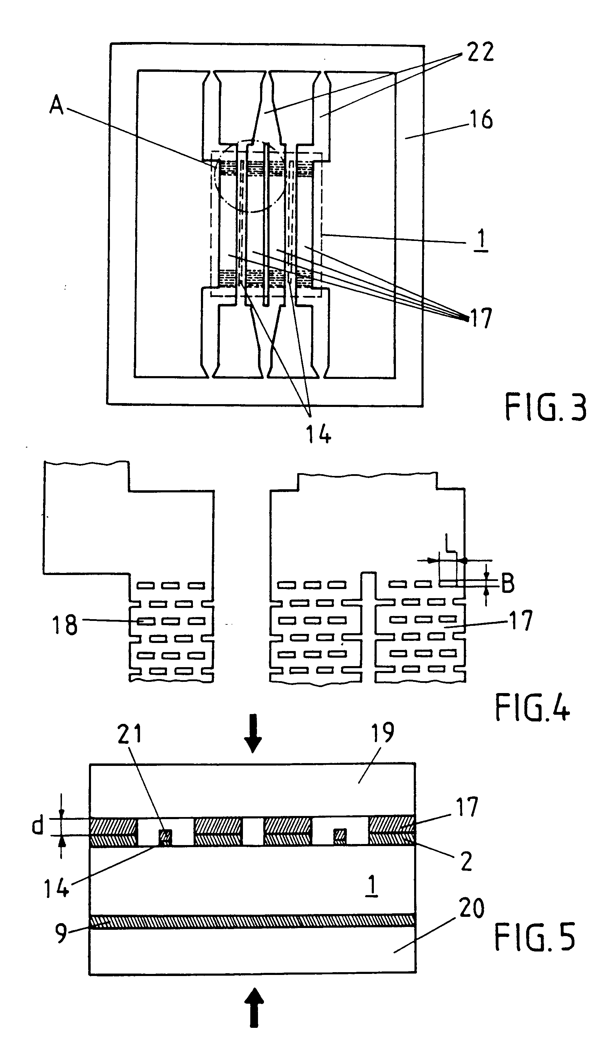

Einbau und Kontaktierung eines FCTh nach Fig.2 erfolgen bei einer bevorzugten Ausführungsform der Erfindung in der in Fig.5 dargestellten Weise:
Das grossflächige Substrat 1 mit dem gemeinsamen Anodenkontakt 9 auf der Anodenseite und den einzelnen Kathodenkontakten 2 der Teilthyristoren auf der Kathodenseite wird zwischen zwei Anpressscheiben 19 und 20 eingespannt und in Richtung der eingezeichneten Pfeile mit einem Druck beaufschlagt.

Bei der in Fig.5 dargestellten Ausführungsform drückt die anodenseitige Anpressscheibe 20 direkt auf den ganzflächigen Anodenkontakt 9 und stellt so die elektrische und thermische Verbindung zum Substrat 1 her.

Die kathodenseitige Anpressscheibe 19 dagegen drückt nicht direkt auf die verschiedenen Kathodenkontakte 2, sondern auf eine Metallfolie 17, die zwischen der Anpressscheibe 19 und den Kathodenkontakten 2 angeordnet und mit den Kathodenkontakten 2 ganzflächig verlötet ist.

Die zwischen den Reihen von Teilthyristoren plazierten, tieferliegenden Gatekontakte 14 sind zu Anschlusszwecken ebenfalls mit einer Metallfolie 21 verlötet, deren Dicke so gewählt ist, dass zu dem kathodenseitigen Anpressscheibe 19 ein hinreichender Abstand besteht.

Die Anordnung gemäss Fig.5 stellt insgesamt einen kombinierten Löt-Druckkontakt dar:
Durch die aufgelötete Metallfolie 17 werden zunächst alle Teilthyristoren auf der Kathodenseite zuverlässig und vom Anpressdruck unabhängig miteinander verbunden. Erst das Sandwich aus Substrat 1 und aufgelöteter Metallfolie 17 wird dann in ein an sich bekanntes Kontaktsystem mit direktem Druckkontakt gebracht.

Kontaktfehler wie beim herkömmlichen direkten Druckkontakt (ohne aufgelötete Metallfolie) sind damit praktisch ausgeschlossen, und das Bauelement zeigt schon bei wesentlich geringeren Anpressdrücken zufriedenstellende Eigenschaften. Insgesamt ergibt sich bei einem deutlich verminderten Einspannaufwand eine merklich erhöhte Zuverlässigkeit.

Zu der grossflächigen Lötung der Metallfolie 17 auf die Kathodenflächen 2 sind einige Anmerkungen zu machen:
Versuche haben gezeigt, dass man solche grossflächigen Bauelemente zuverlässig mit dünnen Metallfolien verlöten kann, wenn letztere mit Dehnfugen und mit Löchern zum Vermeiden von Gaseinschlüssen während des Lötens versehen sind.

Andererseits sind herkömmliche Lotschichten bereits von sich aus bei den in einem druckkontaktierten Leistungshalbleiter auftretenden Betriebsbedingungen - erhöhter Druck (bis 8 N/mm²) und erhöhte Temperatur (bis über 125°C) - weitgehend stabil. Darüberhinaus kann das Fliessen des Lotes unter Druck durch bewusstes Verkleinern des Lotspaltes noch verringert werden.

Zur Vermeidung von Lunkern bei der Lötung sowie zur Veringerung der thermischen Spannungen zwischen dem Si-Substrat und der Metallfolie ist die Folie (z.B. durch entsprechendes Aetzen) als feines Sieb mit einer Vielzahl von flächig verteilten Sieblöchern 18 mit einer Breite B und einer Länge L (Fig.3 und 4) ausgebildet. Gleichzeitig wird durch die Siebform eine einfache visuelle Kontrolle der Lötung möglich.

Wird die derart strukturierte Metallfolie während des Lötvorganges auf das Si-Substrat gepresst, so muss das Lot in die Sieblöcher 18 fliessen. Durch geeignete Auslegung von Lotmenge, Maschenweite und Dicke d der siebförmigen Metallfolie kann der Austritt von Lot dabei verhindert werden, so dass ein minimaler Lotspalt zwischen Folie und Si-Substrat, eine Lötverbindung auch in den Kanten der Sieblöcher 18, und eine optimale Planparallelität der äusseren Oberflächen erreicht wird. Der Druck des Druckkontaktes liegt dann nicht mehr auf dem Lot, sondern wird von der Folie praktisch direkt auf das Si-Substrat übertragen.

Bei Verwendung der siebförmigen Metallfolie können auch Lotpasten eingesetzt werden, da deren Ausgasen nicht zu Lunkern führen kann. Komplizierte Positionierungen von Lotfolie und Kontaktmaterial speziell bei getrennten Anschlüssen auf einer Fläche (z.B. Gate, Kathode) entfallen, wenn die Lotpaste im Siebdruckverfahren auf das Si-Substrat aufgebracht wird.

In der Fig.3 ist an einem bevorzugten Ausführungsbeispiel dargestellt, wie die siebförmigen Metallfolien 17 auf die Kathodenseite eines Substrats 1 gemäss Fig.2 aufgebracht werden. Die Metallfolien 17 sind Teil einer z.B. gestanzten Folienkonfiguration, die einen Rahmen 16 um fasst. Die Metallfolien 17 sind mit dem Rahmen 16 über Anschlussfahnen 22 verbunden und auf diese Weise für die Lötung korrekt positioniert.

Durch die Lötung werden die fünf Teilthyristoren 13 jeder Reihe kathodenseitig durch die jeweilige Metallfolie 17 untereinander verbunden. Die Anschlussfahnen 22 können nach dem Löten abgetrennt werden.

In Fig.3 ist mit A ein Ausschnitt bezeichnet, der in Fig.4 vergrössert wiedergegeben ist und speziell die Art und Anordnung der Sieblöcher 18 in den Metallfolien 17 betrifft. Im Ausführungsbeispiel der Fig.4 sind die Sieblöcher 18 als rechteckige Schlitze mit der Länge L (z.B.: L = 0,6 mm) und der Breite B (z.B.: B = 0,2 mm) ausgeführt.

Wie ein Vergleich der Fig.2-4 deutlich macht, sind die rechteckigen Sieblöcher 18 quer zu den Kathodenfingern 15 angeordnet. Die Breite B ist dabei vorzugsweise kleiner gewählt als die Länge der Kathodenfinger 15. Auf diese Weise wird eine optimale Druckverteilung und Kontaktgabe für die stark strukturierte Kathodenseite des FCTh (bzw. GTO) erreicht.

Die Metallfolien 17 bestehen vorzugsweise im Wesentlichen aus einem Metall der Reihe Cu und Mo. Ihre Dicke d beträgt dabei nur wenige 1/10 mm, insbesondere etwa 0,2 mm. Besonders bewährt haben sich Metallfolien 17, die im Wesentlichen aus Cu bestehen und auf der Lötseite mit einer Schichtenfolge aus Cr, Ni und Au beschichtet sind.

Als Lot hat sich ein PbIn-Lot bewährt, das durch den Pb-Anteil ein gutes Wechsellastverhalten zeigt, und durch den In-Anteil gut lötfähig ist.

Eine Minimierung der beim Löten auftretenden Verwölbung wird durch beidseitige Verwendung von Metallfolien erreicht. Es entsteht ein Sandwich, das bei Bedarf sogar mechanisch nachbearbeitet werden kann (Schleifen, Polieren). Bei Verwendung von polierten Anpressscheiben 19, 20 kann dann mit einem verbesserten Wärmeübergang zwischen Substrat 1 und den Anpressscheiben gerechnet werden.

Werden darüber hinaus für die beiden gleitenden Partner, aufgelötete Folie und Anpressscheibe, Materialien bzw. Oberflächenbehandlungen gewählt, die die Gleiteigenschaften verbessern, so können die bei Wechselbelastung auftretenden Scherkräfte weitgehend vermieden werden. Eine deutliche Erhöhung der Zuverlässigkeit ist dadurch gegeben.

Insgesamt wird mit der Erfindung bei grossflächigen Leistungshalbleiter-Bauelementen eine verbesserte Kontaktierung erreicht, die dem Wechsellastverhalten zugute kommt.

## Patentansprüche

1. Druckkontaktiertes Leistungshalbleiter-Bauelement, umfassend
a) ein Substrat (1) mit einer Anodenseite und einer Kathodenseite;
b) innerhalb des Substrats (1) zwischen der Anodenseite und der Kathodenseite eine Folge von Schichten unterschiedlichen Leitungstyps;
c) auf der Anodenseite des Substrats (1) einen Anodenkontakt (9);
d) auf der Kathodenseite des Substrats (1) einen Kathodenkontakt (2);
e) eine kathodenseitige Anpressscheibe (19), welche auf die Kathodenseite des Substrats (1) drückt; und
f) eine anodenseitige Anpressscheibe (20), welche auf die Anodenseite des Substrats (1) drückt;
g) zwischen wenigstens einer der Anpressscheiben (19,20) und dem zugehörigen Kontakt (2,9) eine Metallfolie (17), die mit dem zugehörigen Kontakt (2,9) ganzflächig verlötet ist;
dadurch gekennzeichnet, dass
h) die Metallfolie (17) als feines Sieb ausgebildet ist, und
i) eine Vielzahl von flächig verteilten Sieblöchern (18) aufweist.

2. Bauelement nach Anspruch 1, dadurch gekennzeichnet, dass
a) die Metallfolie (17) im Wesentlichen aus einem Metall der Reihe Cu und Mo besteht; und
b) die Dicke (d) der Metallfolie (17) wenige 1/10 mm beträgt.

3. Bauelement nach Anspruch 2, dadurch gekennzeichnet, dass die Dicke (d) der Metallfolie (17) etwa 0,2 mm beträgt.

4. Bauelement nach Anspruch 2, dadurch gekennzeichnet, dass
a) die Metallfolie (17) im Wesentlichen aus Cu besteht; und
b) auf der Lötseite mit einer Schichtenfolge aus Cr, Ni und Au beschichtet ist.

5. Bauelement nach Anspruch 1, dadurch gekennzeichnet, dass
a) die Folge von Schichten unterschiedlichen Leitungstyps im Substrat (1) einen Feldgesteuerten Thyristor (FCTh) bildet;
b) der FCTh auf der Kathodenseite eine Vielzahl von länglichen Kathodenfingern (15) aufweist, welche über eine tieferliegende Gateebene (GE) hinausragen; und
c) die Metallfolie (17) zumindest zwischen der kathodenseitigen Anpressscheibe (19) und dem Kathodenkontakt (2) angeordnet ist.

6. Bauelement nach Anspruch 5, dadurch gekennzeichnet, dass
a) die Metallfolie (17) rechteckige Sieblöcher (18) aufweist, welche quer zu den Kathodenfingern (15) verlaufen; und
b) die Breite (B) der Sieblöcher (18) kleiner ist, als die Länge der Kathodenfinger (15).

7. Bauelement nach Anspruch 1, dadurch gekennzeichnet, dass
a) die Folge von Schichten unterschiedlichen Leitungstyps im Substrat (1) einen GTO-Thyristor bildet;
b) der GTO-Thyristor auf der Kathodenseite eine Vielzahl von länglichen Kathodenfingern (15) aufweist, welche über eine tieferliegende Gateebene (GE) hinausragen; und
c) die Metallfolie (17) zumindest zwischen der kathodenseitigen Anpressscheibe (19) und dem Kathodenkontakt (2) angeordnet ist.

8. Bauelement nach Anspruch 7, dadurch gekennzeichnet, dass
a) die Metallfolie (17) rechteckige Sieblöcher (18) aufweist, welche quer zu den Kathodenfingern (15) verlaufen; und
b) die Breite (B) der Sieblöcher (18) kleiner ist, als die Länge der Kathodenfinger (15).

9. Bauelement nach Anspruch 1, dadurch gekennzeichnet, dass als Lot ein PbIn-Lot verwendet wird.

## Claims

1. Pressure-contacted power-semiconductor element, comprising
a) a substrate (1) with an anode side and a cathode side;
b) inside the substrate (1), between the anode side and the cathode side, a series of layers of different conduction types;
c) an anode contact (9) on the anode side of the substrate (1);
d) a cathode contact (2) on the cathode side of the substrate (1);
e) a cathode-side compression plate (19), which presses against the cathode side of the substrate (1); and
f) an anode-side compression plate (20), which presses against the anode side of the substrate (1);
g) between at least one of the compression plates (19,20) and the associated contact (2,9) a metal foil (17) which is soldered to the associated contact (2,9) over its whole surface; characterised in that
h) the metal foil (17) is constructed in the form of a fine screen and
i) has a large number of screen holes (18) distributed over its surface.

2. Component according to Claim 1, characterised in that
a) the metal foil (17) consists primarily of a metal from the Cu and Mo series; and
b) the thickness (d) of the metal foil (17) is a few 1/10 mm.

3. Component according to Claim 2, characterised in that the thickness (d) of the metal foil (17) is about 0.2 mm.

4. Component according to Claim 2, characterised in that
a) the metal foil (17) consists primarily of Cu; and
b) is coated on the solder side with a series of layers of Cr, Ni and Au.

5. Component according to Claim 1, characterised in that
a) the series of layers of different conduction types in the substrate (1) forms a field-controlled thyristor (FCTh);
b) the FCTh on the cathode side exhibits a large number of elongate cathode fingers (15), which project out of a deeper-lying gate level (GE);
c) the metal foil (17) is arranged at least between the cathode-side compression plate (19) and the cathode contact (2).

6. Component according to Claim 5, characterised in that
a) the metal foil (17) exhibits rectangular screen holes (18), which run at right angles to the cathode fingers (15); and
b) the width (B) of the screen holes (18) is smaller than the length of the cathode fingers (15).

7. Component according to Claim 1, characterised in that
a) the series of layers of different conduction types in the substrate (1) forms a GTO thyristor;
b) the GTO thyristor exhibits on the cathode side a large number of elongate cathode fingers (15), which project out of a deeper-lying gate level (GE); and
c) the metal foil (17) is arranged at least between the cathode-side compression plate (19) and the cathode contact (2).

8. Component according to Claim 7, characterised in that
a) the metal foil (17) exhibits rectangular screen holes (18), which run at right angles to the cathode fingers (15); and
b) the width (B) of the screen holes (18) is smaller than the length of the cathode fingers (15).

9. Component according to Claim 1, characterised in that a Pb-In solder is employed as the solder.

## Revendications

1. Composant semi-conducteur de puissance à contact par pression, comprenant
a) un substrat (1) avec une face anodique et une face cathodique;
b) à l'intérieur du substrat (1) entre la face anodique et la face cathodique, une succession de couches de nature conductrice différente;
c) un contact anodique (9) sur la face anodique du substrat (1);
d) un contact cathodique (2) sur la face cathodique du substrat (1);
e) un disque de pression (19) du côté cathodique, qui appuie sur la face cathodique du substrat (1);
f) un disque de pression (20) du côté anodique, qui appuie sur la face anodique du substrat (1);
g) entre au moins un des disques de pression (19, 20) et le contact respectif (2, 9), une feuille métallique (17) qui est brasée sur toute sa surface avec le contact respectif (2, 9);
caractérisé en ce que
h) la feuille métallique (17) est finement perforée, et en ce que
i) elle présente une pluralité de perforations (18) réparties dans sa surface.

2. Composant suivant la revendication 1, caractérisé en ce que
a) la feuille métallique (17) se compose essentiellement d'un métal de la série Cu et Mo; et en ce que
b) l'épaisseur (d) de la feuille métallique (17) s'élève à quelques 0,1 mm.

3. Composant suivant la revendication 2, caractérisé en ce que l'épaisseur (d) de la feuille métallique (17) vaut environ 0,2 mm.

4. Composant suivant la revendication 2, caractérisé en ce que
a) la feuille métallique (17) se compose essentiellement de Cu; et en ce que
b) elle est revêtue sur la face de brasage d'une succession de couches de Cr, Ni et Au.

5. Composant suivant la revendication 1, caractérisé en ce que
a) la succession de couches de nature conductrice différente forme dans le substrat (1) un thyristor commandé par le champ (FCTh); en ce que
b) le FCTh présente sur la face cathodique une pluralité de doigts de cathode allongés (15), qui sont saillants au-dessus d'un plan de porte GE) situé à plus grande profondeur; et en ce que
c) la feuille métallique (17) est disposée au moins entre le disque de pression (19) du côté cathodique et le contact cathodique (2).

6. Composant suivant la revendication 5, caractérisé en ce que
a) la feuille métallique (17) présente des perforations (18) rectangulaires, qui sont orientées transversalement par rapport aux doigts de cathode (15); et en ce que
b) la largeur (B) des perforations (18) est plus petite que la longueur des doigts de cathode (15).

7. Composant suivant la revendication 1, caractérisé en ce que
a) la succession de couches de nature conductrice différente forme dans le substrat (1) un thyristor GTO; en ce que
b) le thyristor GTO présente sur la face cathodique une pluralité de doigts de cathode allongés (15), qui sont saillants au-dessus d'un plan de porte (GE) situé à plus grande profondeur; et en ce que
c) la feuille métallique (17) est disposée au moins entre le disque de pression (19) du côté cathodique et le contact cathodique (2).

8. Composant suivant la revendication 7, caractérisé en ce que
a) la feuille métallique (17) présente des perforations (18) rectangulaires, qui sont orientées transversalement par rapport aux doigts de cathode (15); et en ce que
b) la largeur (B) des perforations (18) est plus petite que la longueur des doigts de cathode (15).

9. Composant suivant la revendication 1, caractérisé en ce que l'on utilise en guise de métal de brasage un métal de brasage constitué de PbIn.
